# EUROPÄISCHE PATENTSCHRIFT

(11) **EP 1 068 645 B1**
(45) Veröffentlichungstag und Bekanntmachung des Hinweises auf die Patenterteilung: **07.05.2014**
(21) Anmeldenummer: 99923389.3
(22) Anmeldetag: 23.03.1999
(51) Int. Cl.: H01L 27/115, H01L 21/8247, H01L 21/762

(54) **SPEICHERZELLENANORDNUNG UND VERFAHREN ZU IHRER HERSTELLUNG**
STORAGE CELL ARRANGEMENT AND METHOD FOR PRODUCING SAME
ENSEMBLE DE CELLULES MEMOIRES ET SON PROCEDE DE REALISATION

(30) Priorität: 24.03.1998 DE 19812947
(43) Veröffentlichungstag der Anmeldung: 17.01.2001
(73) Patentinhaber: Infineon Technologies AG, 85579 Neubiberg (DE)
(72) Erfinder: REISINGER, Hans, D-82031 Grünwald (DE); STENGL, Reinhard, D-86391 Stadtbergen (DE); WILLER, Josef, D-85521 Riemerling (DE); HOFMANN, Franz, D-80995 München (DE); KRAUTSCHNEIDER, Wolfgang, D-83104 Hohenthann (DE); VON BASSE, Paul-Werner, D-82515 Wolfratshausen (DE)
(74) Vertreter: Kindermann, Peter
(86) Internationale Anmeldenummer: PCT/DE1999/000867
(87) Internationale Veröffentlichungsnummer: WO 1999/049518

(56) Entgegenhaltungen:
- WO-A-98/06140
- DE-C- 19 637 389
- US-A- 5 290 723
- US-A- 5 343 423
- US-A- 5 429 988

## Beschreibung

Die Erfindung betrifft eine Speicherzellenanordnung, bei der im Bereich einer Hauptfläche eines Halbleitersubstrats mehrere Speicherzellen vorhanden sind, bei der die Speicherzellen in im wesentlichen parallel verlaufenden Speicherzellenzeilen angeordnet sind, und bei der benachbarte Speicherzellenzeilen durch wenigstens einen Isolationsgraben gegeneinander isoliert sind, wobei die Speicherzellenanordnung wenigstens ein Gatedielektrikum, das ein Material mit Ladungsträger-Haftstellen enthält, aufweist, und bei der die Speicherzellenzeilen jeweils wenigstens ein dotiertes Gebiet aufweisen.

Die Erfindung betrifft ferner ein Verfahren zur Herstellung einer Speicherzellenanordnung, bei dem im Bereich einer Hauptfläche eines Halbleitersubstrats mehrere Speicherzellenzeilen erzeugt und gegeneinander isoliert werden.

Speicherzellen werden in weiten Technologiegebieten eingesetzt. Bei den Speicherzellen kann es sich sowohl um Festwertspeicher handeln, die als ROM (Read Only Memory) bezeichnet werden, als auch um programmierbare Speicher, die als PROM (Programmable ROM) bezeichnet werden.

Speicherzellenanordnungen auf Halbleitersubstraten zeichnen sich dadurch aus, daß sie einen wahlfreien Zugriff auf die in ihnen gespeicherte Information erlauben. Sie enthalten eine Vielzahl von Transistoren. Beim Lesevorgang werden einem Stromfluß durch den Transistor oder einem Sperren des Transistors die logischen Zustände 1 oder 0 zugeordnet. Üblicherweise wird die Speicherung der Information dadurch bewirkt, daß MOS-Transistoren eingesetzt werden, deren Kanalgebiete eine der gewünschten Sperreigenschaft entsprechende Dotierung aufweisen.

Eine gattungsgemäße Speicherzellenanordnung ist in der DE-OS 195 10 042 vorgeschlagen worden. Diese Speicherzellenanordnung enthält in Zeilen angeordnete MOS-Transistoren. In jeder Zeile sind die MOS-Transistoren in Reihe geschaltet. Zur Erhöhung der Speicherdichte sind benachbarte Zeilen jeweils abwechselnd am Boden von streifenförmigen Längsgräben und zwischen benachbarten streifenförmigen Längsgräben an der Oberfläche des Substrats angeordnet. Miteinander verbundene Source/Drain-Gebiete sind als zusammenhängendes dotiertes Gebiet ausgebildet. Durch ein zeilenweises Ansteuern ist es möglich, diese Speicherzellenanordnung auszulesen.

Die Programmierung der bekannten Speicherzellenanordnung erfolgt bei ihrer Herstellung. Für viele Anwendungen werden jedoch Speicher benötigt, in die Daten durch elektrische Programmierung eingeschrieben werden können. In elektrisch programmierbaren Speicherzellenanordnungen wird eine Speichermöglichkeit für Information durch eine geeignete Ausgestaltung von MOS-Transistoren bewirkt. So ist es beispielsweise möglich, daß zwischen dem Gate und dem Kanalgebiet eines MOS-Transistors ein sogenanntes floatendes Gate angeordnet ist. Ein derartiges floatendes Gate kann mit einer elektrischen Ladung versehen werden. In diesem Fall hängt die Einsatzspannung des MOS-Transistors von der auf dem floatenden Gate befindlichen Ladung ab. Es ist jedoch gleichfalls möglich, den MOS-Transistor so auszugestalten, daß sein Gatedielektrikum eine Mehrfachschicht aus SiO₂ und Si₃N₄ enthält. An der Grenzfläche zwischen diesen beiden Schichten können elektrische Ladungsträger an Haftstellen festgehalten werden. In diesem Fall hängt die Einsatzspannung des MOS-Transistors von der auf den Haftstellen befindlichen Ladung ab. Die Abhängigkeit der Einsatzspannung des MOS-Transistors von der in den genannten Bereichen befindlichen Ladung kann zur elektrischen Programmierung genutzt werden.

Diese Speicherzellenanordnung zeichnet sich dadurch aus, daß der für die Speicherzellen erforderliche Flächenbedarf von 4 F² auf 2 F² verringert wurde, wobei F die minimale Strukturbreite des für die Herstellung eingesetzten photolitographischen Prozesses ist. Nachteilig ist jedoch, daß eine weitere Erhöhung der Anzahl der Speicherzellen je Flächeneinheit hierbei nicht möglich ist.

Eine weitere bekannte Speicherzellenanordnung ist in der US-PS 5 306 941 dargestellt. Bei dieser Speicherzellenanordnung sind im Randbereich von Speicherzellenstegen Bitleitungen angeordnet, wobei die Bitleitungen benachbarter Speicherzellenstege einander zugewandt sind. Die Bitleitungen sind dabei jeweils durch einen mit einem isolierenden Material gefüllten Isolationsgraben voneinander getrennt. Dieses Dokument offenbart ferner ein Verfahren zur Herstellung einer Speicherzellenanordnung, bei dem Speicherzellenstege dadurch gebildet werden, daß in ein Halbleitersubstrat Isolationsgräben geätzt werden. Nach dem Ätzen der Isolationsgräben erfolgt eine Diffusion eines Dotierstoffs, wobei durch die Diffusion Bitleitungen gebildet werden. Ferner wird auf und zwischen den Speicherzellenzeilen ein Gatedielektrikum gebildet. Diese gattungsgemäße Speicherzellenanordnung eignet sich für Strukturgrößen von mindestens 0,5 µm und für einen ROM-Festwertspeicher. Eine elektrische Programmierung ist hierbei nicht möglich.

Aus der Druckschrift US-A-5 343 423 ist eine Speicherzellenanordnung mit einer so genannten "common source"-Architektur bekannt, wobei voneinander getrennte Speicherzellen einen gemeinsamen Source-Anschluss, eine Vielzahl von Drain-Anschlüssen sowie eine Vielzahl von Gate-Anschlüssen (Wortleitungen) aufweisen.

Die Druckschrift DE 196 37 389 C offenbart eine DRAM-Speicherzellenanordnung, wobei ein vertikaler MOS-Auswahltransistor mit einem Speicherkondensator verbunden ist. Hierbei werden vergrabene Bitleitungen verwendet.

Ferner ist aus der Druckschrift WO 98 06140 A ein Verfahren zum Betrieb einer Speicherzellenanordnung bekannt, wobei als Gatedielektrikum für den Speichertransistor ein ONO-Mehrschichtaufbau (Oxid-Nitrid-Oxid) mit Ladungshalteeigenschaften verwendet wird.

Der Erfindung liegt die Aufgabe zugrunde, eine Speicherzellenanordnung sowie ein zugehöriges Herstellungsverfahren zu schaffen, wobei eine möglichst große Anzahl von Speicherzellen auf möglichst kleinem Raum angeordnet werden kann.

Erfindungsgemäß wird diese Aufgabe hinsichtlich der Speicherzellenanordnung durch die Merkmale des Patentanspruchs 1 und hinsichtlich des Verfahrens durch die Maßnahmen des Patentanspruchs 9 gelöst.

Insbesondere durch das alternierende Ausbilden von ersten und zweiten Wortleitungen im Wesentlichen senkrecht zu den Speicherzellenzeilen an der Oberfläche eines Gatedielektrikums derart, dass der Abstand zwischen den Wortleitungen kleiner ist als ihre Breite, erhält man eine maximale Integrationsdichte.

Die Erfindung sieht ferner vor, eine Speicherzellenanordnung mit in Zeilen angeordneten Speicherzellen so auszugestalten, daß die Zeilen mit den Speicherzellen in der Form von Stegen über eine Ebene des Halbleitersubstrats hinausragen und dabei durch Gräben voneinander getrennt sind. Die Gräben, beziehungsweise die sonstigen Zwischenräume zwischen den Speicherzellenzeilen sind mit einem isolierenden Material gefüllt, das gleichfalls über die Ebene des Halbleitersubstrats hinausragt.

Besonders vorteilhaft ist es, daß die Speicherzellenanordnung so ausgestaltet ist, daß der Isolationsgraben eine Höhe von 50 nm bis 200 nm aufweist.

Das erfindungsgemäße Verfahren zur Herstellung der Speicherzellenanordnung wird ferner so durchgeführt, daß auf die Hauptfläche des Halbleitersubstrats zuerst erste Bereiche einer Ätzmaske aufgebracht werden, daß dann an Flanken der Bereiche Abstandsstücke erzeugt werden, daß nach dem Erzeugen der Abstandsstücke zwischen den ersten Bereichen zweite Bereiche der Ätzmaske gebildet werden und daß in einem späteren Verfahrensschritt eine Ätzung der Abstandsstücke selektiv zu den ersten Bereichen und den zweiten Bereichen der Ätzmaske erfolgt.

Es ist besonders vorteilhaft, dieses Verfahren so durchzuführen, daß die Abstandsstücke dadurch erzeugt werden, daß auf die ersten Bereiche der Ätzmaske und auf nicht durch die ersten Bereiche der Ätzmaske bedeckte Bereiche des Halbleitersubstrats eine Deckschicht abgeschieden wird und daß dann Bereiche der Deckschicht, die sich parallel zu der Hauptfläche des Halbleitersubstrats erstrecken, weggeätzt werden.

Ferner ist es zweckmäßig, daß die ersten Bereiche der Ätzmaske so aufgebracht werden, daß sich zwischen ihnen wenigstens ein Zwischenraum bildet und daß ein Material aufgebracht wird, das in den Zwischenraum gelangt, so daß sich in dem Zwischenraum wenigstens einer der zweiten Bereiche der Ätzmaske bildet.

Dies geschieht vorzugsweise dadurch, daß das Material so aufgebracht wird, daß es auch die ersten Bereiche der Ätzmaske und die Abstandsstücke bedeckt.

Speicherzellenanordnungen mit im wesentlichen parallelen Spei-cherzellenzeilen werden-bevorzugt so hergestellt, daß die ersten Bereiche der Ätzmaske als im wesentlichen parallele Stege erzeugt werden.

Zur Erzeugung von Speicherzellenanordnungen mit im wesentlichen parallelen Speicherzellenzeilen ist es besonders zweckmäßig, daß die zweiten Bereiche der Ätzmaske so erzeugt werden, daß sie im wesentlichen parallele Stege bilden.

Es ist besonders vorteilhaft das Verfahren so durchzuführen, daß auf einem Halbleitersubstrat, das Silizium enthält, eine Maske aufgetragen wird, deren erste Bereiche und deren zweite Bereiche aus Siliziumoxid SiO₂ bestehen und daß die Abstandsstücke aus Siliziumnitrid Si₃N₄ gebildet werden.

Es ist zweckmäßig, dieses Verfahren so durchzuführen, daß die Ätzung der Abstandsstücke selektiv zu den ersten Bereichen und den zweiten Bereichen der Ätzmaske mit Phosphorsäure als Ätzmittel erfolgt.

Weitere Vorteile und Besonderheiten der Erfindung ergeben sich aus den Unteransprüchen und der nachfolgenden Darstellung bevorzugter Ausführungsbeispiele anhand der Zeichnungen.

Von den Zeichnungen zeigt
- Figur 1: eine Aufsicht auf eine Speicherzellenanordnung, in der benachbarte Speicherzellenzeilen durch isolierende Gräben gegeneinander isoliert sind,
- Figur 2: einen Querschnitt durch das Halbleitersubstrat entlang der in Figur 1 dargestellten Linie VII - VII nach Auftragen von ersten Bereichen einer Ätzmaske,
- Figur 3: das in Figur 2 dargestellte Halbleitersubstrat nach einem Auftragen einer Schicht,
- Figur 4: das in Figur 3 dargestellte Halbleitersubstrat nach einem Wegätzen der Schicht mit Ausnahme von Abstandsstücken an den ersten Bereichen und Auftragen von zweiten Bereichen der Ätzmaske,
- Figur 5: einen Querschnitt durch das Halbleitersubstrat entlang der Linie VII - VII mit auf dem Halbleitersubstrat befindlicher Ätzmaske nach Wegätzen der Abstandsstücke und
- Figur 6: einen Querschnitt durch das Halbleitersubstrat entlang der Linie VII - VII nach Ätzung von Isolationsgräben, Entfernen der Ätzmaske und Füllen der Isolationsgräben mit einem isolierenden Material,
- Figur 7: einen Querschnitt durch das Halbleitersubstrat entlang der Linie VII - VII nach Auftragen einer dielektrischen Mehrfachschicht und Aufwachsen einer ersten Elektrodenschicht,
- Figur 8: einen Querschnitt durch das Halbleitersubstrat entlang der in den Figuren 1 und 7 dargestellten Linie VIII-VIII nach einer Strukturierung der ersten Elektrodenschicht und dem Abscheiden eines weiteren isolierenden Materials,
- Figur 9: einen Querschnitt durch das Halbleitersubstrat entlang der Linie VIII-VIII nach Durchführung einer anisotropen Ätzung zur Bildung von Abstandsstücken,
- Figur 10: einen Querschnitt durch das Halbleitersubstrat entlang der Linie VIII-VIII nach einem weiteren Ätzvorgang,
- Figur 11: einen Querschnitt durch das Halbleitersubstrat entlang der Linie VIII-VIII nach Aufwachsen einer dielektrischen Schicht und Abscheidung einer zweiten Elektrodenschicht,
- Figur 12: einen Querschnitt durch das Halbleitersubstrat entlang der Linie VIII-VIII nach einer Strukturierung der zweiten Elektrodenschicht,
- Figur 13: eine Aufsicht auf einen Ausschnitts des Halbleitersubstrats nach Bildung von Kontakten zu den strukturierten, als Gateelektroden wirkenden Elektrodenschichten,

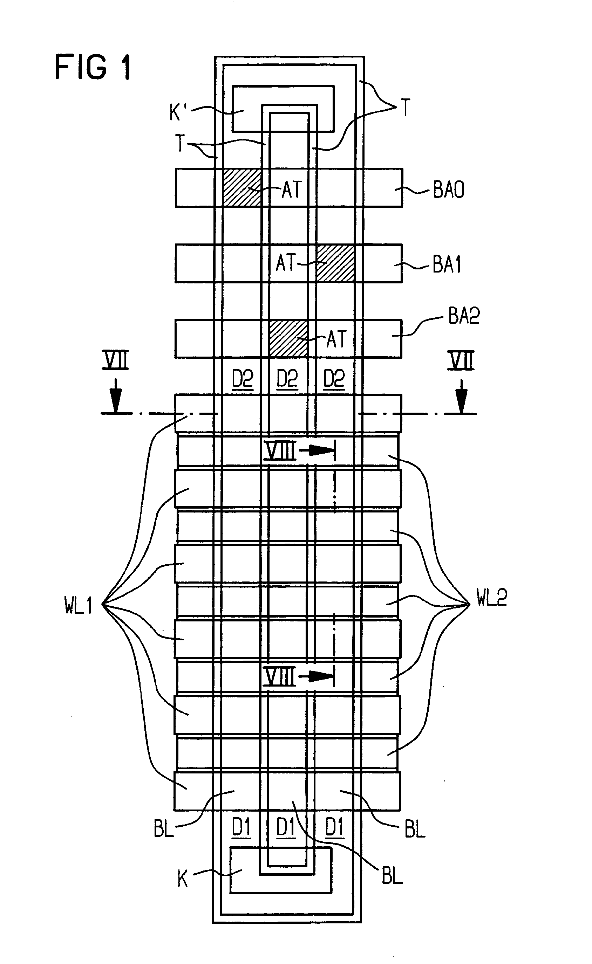

In Figur 1 ist eine Aufsicht auf eine Speicherzellenanordnung mit ersten Wortleitungen WL 1 und zweiten Wortleitungen WL 2, die alternierend angeordnet sind, dargestellt.

Der Abstand zwischen benachbarten Wortleitungen WL 1 und WL 2 ist dabei geringer als die Breite der Wortleitungen WL 1, WL 2. Quer zu den Wortleitungen WL 1, WL 2 verlaufen Bitleitungen BL, die jeweils ein erstes dotiertes Gebiet D 1, ein zweites dotiertes Gebiet D 2 aufweisen. Die Speicherzellenanordnung enthält ferner ein Gatedielektrikum und Gateelektroden. Die Wortleitungen WL 1, WL 2 überlappen mit den Bitleitungen BL in Bereichen, die einer Speicherzelle der Speicherzellenanordnung entsprechen.

Die Bitleitungen BL sind jeweils in einem oberen Bereich von Stegen angeordnet. Die einzelnen Bitleitungen BL sind gegeneinander durch Isolationsgräben (Trenches) T isoliert. Die Isolationsgräben T sind wesentlich schmäler als die Bitleitungen BL und weisen eine Dicke von 10 nm bis 100 nm, vorzugsweise 30 bis 60 nm auf, wobei sich das hier dargestellte Ausführungsbeispiel auf eine Breite der Isolationsgräben T von etwa 50 nm bezieht.

Der Abstand der Mitten benachbarter erster Wortleitungen WL 1 und zweiter Wortleitungen WL 2 ist möglichst klein gewählt und entspricht vorzugsweise der minimalen Strukturgröße F des Herstellungsprozesses der Speicherzellenanordnung. Der Abstand zwischen den Mitten benachbarter Bitleitungen BL beträgt ebenfalls vorzugsweise eine minimale Strukturgröße F. Somit beträgt der Platzbedarf pro Speicherzelle, die als Kreuzung einer der Wortleitungen WL 1, WL 2 mit einer der Bitleitungen BL definiert wird, 1 F².

Außerhalb eines Feldes, in dem die Speicherzellen angeordnet sind, ist ein Dekoder angeordnet, der quer zu den Bitleitungen BL verlaufende Bitauswahlleitungen BA0, BA1 und BA2 aufweist. Mehrere benachbarte Bitleitungen BL - im dargestellten Fall drei - sind über eine nicht dargestellte, vorzugsweise in einer höheren Strukturebene angeordnete, Metallisierung zu Knoten K, K' zusammengefaßt. Zwischen dem Knoten K' und dem zweiten dotierten Gebiet D 2 sind so viele Bitauswahlleitungen BA0, BA1 und BA2 angeordnet, wie Bitleitungen BL in dem Knoten K' zusammengeführt sind.

Über die Bitauswahlleitungen BA sind Auswahltransistoren AT des Dekoders ansteuerbar. Die Auswahltransistoren AT befinden sich an einzelnen Kreuzungspunkten der Bitauswahlleitungen BA mit den Bitleitungen BL. Hierbei ist pro Bitleitung BL ein Kreuzungspunkt mit einem Auswahltransistor AT versehen.

An Kreuzungspunkten der Bitauswahlleitungen BA mit den Bitleitungen BL, an denen keine Auswahltransistoren AT angeordnet sind, ist eine Kanaldotierung vorgesehen. Durch die Kanaldotierung entsteht an jedem dieser Kreuzungspunkte ein parasitärer MOS-Transistor, der eine Einsatzsspannung aufweist, die so groß ist, daß er unabhängig von einem an einer entsprechenden Bitauswahlleitung BA anliegenden Pegel leitet. Vorzugsweise ist diese Einsatzsspannung negativ.

Diese Speicherzellenanordnung wird vorzugsweise auf die im folgenden dargestellte Art hergestellt:
In einem Halbleitersubstrat 10 aus zum Beispiel p-dotiertem monokristallinen Silizium mit einer Grundkonzentration eines Dotierstoffs wie Bor von vorzugsweise 1 x 10¹⁵ cm⁻³ bis 1 x 10¹⁶ cm⁻³, beispielsweise 2 x 10¹⁵ cm⁻³, wird eine p-dotierte Wanne 15 mit einer Dotierstoffkonzentration von zum Beispiel 1 x 10¹⁷ cm⁻³ durch Implantation gebildet. Die Tiefe der p-dotierten Wanne 15 beträgt zum Beispiel etwa 1 µm.

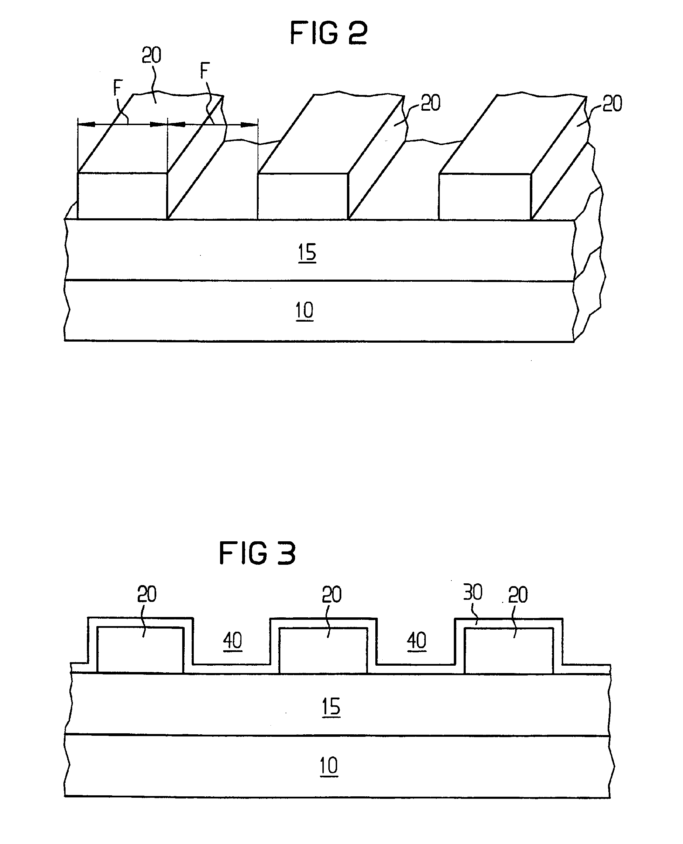

Danach werden erste Bereiche einer Maske aufgetragen. Die ersten Bereiche der Maske weisen die Form von parallel verlaufenden, sich über eine der Hauptflächen des Halbleitersubstrats 10 erstreckenden Stegen 20 auf. Die Stege 20 weisen eine Breite auf, die im wesentlichen einer minimal herstellbaren Strukturgröße F entspricht. Vorzugsweise liegt F im Bereich von 0,1 µm bis 0,5 µm. Dieser Bearbeitungszustand des Halbleitersubstrats ist in Figur 2 dargestellt.

Die ersten Bereiche der Maske, das heißt hier die Stege 20, bestehen beispielsweise aus nach einem TEOS(Si(OC₂H₅)₄)-Verfahren gebildeten Siliziumoxid SiO₂. Das TEOS-Verfahren wird vorzugsweise so durchgeführt, daß Tetra-Ethyl-Ortho-Silikat Si(OC₂H₅)₄ bei einer Temperatur von ungefähr 700 °C und einem Druck im Bereich von etwa 40 Pa in Siliziumoxid umgewandelt wird.

Auf das so bearbeitete Halbleitersubstrat wird konform eine Deckschicht 30 aufgebracht (siehe Figur 3). Die aufgebrachte Deckschicht 30 besteht beispielsweise aus Siliziumnitrid Si₃N₄. Die Dicke der Deckschicht 30 beträgt vorzugsweise 5 nm bis 50 nm, wobei eine Dicke im Bereich von 20 nm bevorzugt ist.

Die Deckschicht 30 wird vorzugsweise nach einem CVD (Chemical Vapour Deposition)-Verfahren aufgebracht, insbesondere nach einem LPCVD (Low Pressure CVD)-Verfahren. Eine besonders geeignete Variante zur Bildung der Deckschicht 30 nach dem LPCVD-Verfahren zeichnet sich dadurch aus, daß Dichlorsilan (SiH₂CL₂) unter Zugabe von Ammoniak (NH₃) bei einer Temperatur im Bereich von etwa 750 °C in einem Plasma bei einem Druck zwischen 10 Pa und 100 Pa, bevorzugt 30 Pa, in Siliziumnitrid (Si₃N₄) umgewandelt wird.

Anschließend erfolgt ein Wegätzen der Deckschicht 30 in Bereichen, die sich parallel zu einer Hauptfläche des Halbleitersubstrats 10 erstrecken, durch einen anisotropen Trokkenätzprozeß. Dadurch wird die Deckschicht 30 auf der oberen Oberfläche der Stege 20 und im Bodenbereich von Gräben 40 entfernt. Das Entfernen der Deckschicht 30 erfolgt mit einem Ätzmittel, das die Deckschicht 30 selektiv zu dem Material der Stege 20 und zu dem Halbleitersubstrat 10 ätzt. Bei einer aus Si₃N₄ bestehenden Deckschicht 30, die sich auf Stegen 20 aus SiO₂ sowie auf einer Oberfläche des Halbleitersubstrats 10 befindet, eignet sich als Ätzmittel für eine derartige selektive Ätzung CHF₃ besonders gut.

Der Ätzvorgang erfolgt soweit, bis die Deckschicht 30 auf den oberen Oberflächen der Stege 20 sowie im Bereich der Böden der Gräben 40 vollständig entfernt ist. Hierdurch bleiben lediglich im Seitenbereich der Stege 20 Abstandsstücke (Spacer) 50 stehen. Die Abstandsstücke 50 weisen eine Breite von etwa 50 nm auf. Dazu ist eine Dicke der Deckschicht 30 von 50 nm erforderlich.

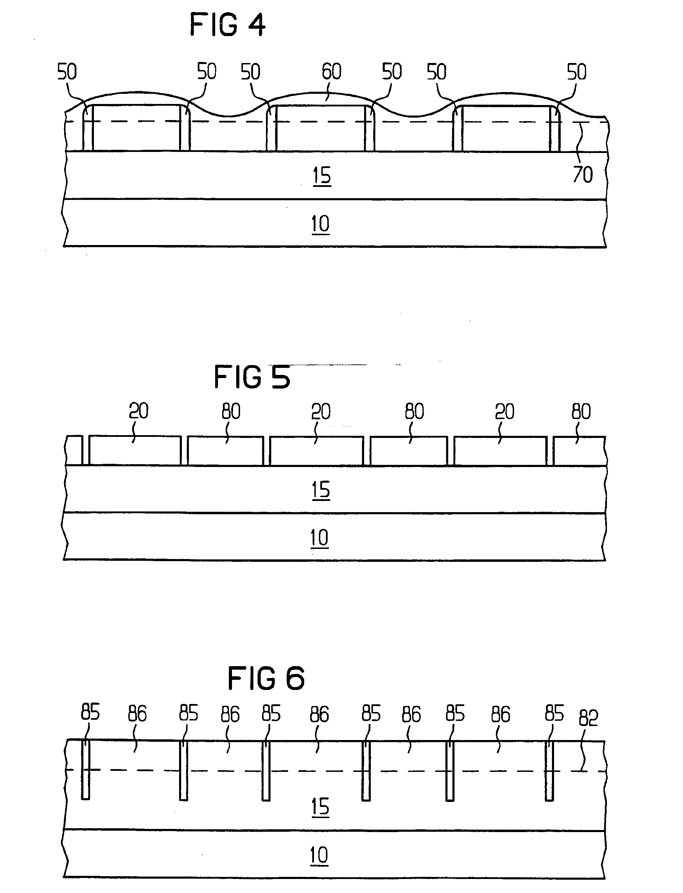

In einem nächsten Verfahrensschritt erfolgt eine Abscheidung eines Materials 60, das vorzugsweise die gleiche chemische Zusammensetzung aufweist wie die ersten Bereiche der Ätzmaske. Das Material 60 wird so dick aufgebracht, daß es die Gräben 40 möglichst weitgehend füllt. Zweckmäßigerweise wird das Verfahren so durchgeführt, daß alle Bereiche der Gräben 40 bis zu einer Linie 70 mit dem Material 60 gefüllt sind. Dieser Bearbeitungszustand des Halbleitersubstrats ist in Figur 4 dargestellt.

Die so entstandene Struktur wird anschließend mit einem geeigneten Planarisierungsprozeß, beispielsweise durch chemisch-mechanisches Polieren (CMP) so planarisiert, daß nur bis zu der Linie 70 reichende Bereiche stehen bleiben.

Danach werden die Abstandsstücke 50 durch eine selektive Ätzung, beispielsweise mit Phosphorsäure bei einer vorzugsweise erhöhten Temperatur entfernt. Konzentrierte Phosphorsäure weist eine besonders hohe Selektivität für eine Nitridschicht auf. Grundsätzlich ist es möglich, den Ätzvorgang bei Raumtemperatur erfolgen zu lassen, jedoch ist es zu einer Beschleunigung des Ätzprozesses sinnvoller, ihn bei einer erhöhten Temperatur durchzuführen. Besonders zweckmäßig ist es, den Ätzprozeß mit einer Temperatur im Bereich um etwa 160 °C durchzuführen.

Durch das Entfernen der Abstandsstücke 50 bildet sich eine Ätzmaske, deren ersten Bereiche durch die ursprünglich aufgebrachten Stege 20 gebildet werden. Zweite Bereiche der Ätzmaske werden durch freigelegte Stege 80 des Materials 60 gebildet. Die freigelegten Stege 80 befinden sich an den Stellen, an denen sich in vorherigen Prozeßschritten der Graben 40 befand. Die Stege 80 haben die gleiche Breite wie der ursprüngliche Graben 40, so daß sie weniger breit sind als F. Die Breite der Stege 80 ist um 2 d gegenüber F verringert. Hierbei bezeichnet d die Dicke der Abstandsstücke 50. Bei F = 200 nm und d = 20 nm ergibt sich somit eine Breite der Stege 80 von 160 nm. Dieser Bearbeitungszustand ist in Figur 5 dargestellt.

Mit Hilfe der verbleibenden, durch die Stege 20 und 80 gebildeten Ätzmaske wird ein Ätzprozeß, beispielsweise mehrstufig über einen ersten Ätzschritt mit einem Gasgemisch aus CF₄ und O₂ oder CHF₃ und O₂ und über einen zweiten Ätzschritt mit einem HBr-haltigen Gas durchgeführt, so daß sich in dem Halbleitersubstrat 10 unterhalb der Stellen, an denen sich in einem vorherigen Prozeßschritt die Abstandsstücke 50 befanden, Isolationsgräben 85 bilden. Die Isolationsgräben 85 sind in der Aufsichtsdarstellung in Figur 1 mit dem Bezugszeichen T gekennzeichnet. Die Isolationsgräben 85 weisen eine Tiefe von 20 nm bis 200 nm auf, wobei 100 nm ein besonders bevorzugter Wert ist. Vorzugsweise sind die Isolationsgräben 85 ungefähr 5 mal so tief wie breit. Nach dem Atzen der Isolationsgräben 85 wird die durch die Stege 20 und 80 gebildete Ätzmaske entfernt.

Anschließend werden die Isolationsgräben 85 mit einem Isolationsmaterial gefüllt. Als Füllmaterial eignet sich SiO₂ besonders. Nach dem Füllen der Isolationsgräben 85 mit dem Isolationsmaterial erfolgt ein Planarisierungsvorgang, vorzugsweise ein Prozeß des chemisch-mechanischen Planarisierens. Der so erreichte Bearbeitungszustand des Halbleitersubstrats ist in Figur 6 dargestellt.

Nachdem ein Streuoxid in einer Schichtdicke von beispielsweise 5 nm aufgebracht ist, werden Bitleitungen 86 erzeugt, indem bis zu einer Linie 82 ein Dotierstoff, beispielsweise Bor in das Halbleitersubstrat 10 implantiert wird. Vorzugsweise ist der Dotierstoff vom gleichen Leitfähigkeitstyp wie der Dotierstoff im Bereich der Wanne 15. Bei einer Konzentration des Dotierstoffs in den Bitleitungen 86 von beispielsweise 1 x 10¹⁷ cm⁻³ bilden sich Kanalgebiete von Transistoren, die eine Einsatzspannung von typischerweise 0,5 V aufweisen. Dieser als Einsatzspannungsimplantation bezeichnete Implantationsvorgang erfolgt zum Beispiel mit einer Dosis von 3 x 10¹² cm⁻² und einer Energie von 25 keV (nicht dargestellt). Somit bilden sich zwischen den Isolationsgräben 85 Speicherzellenzeilen. Diese Speicherzellenzeilen weisen die Form von über das Halbleitersubstrat 10 hinausragenden Stegen auf.

Anschließend wird eine Programmiermaske zum Beispiel aus einem Photolack durch photolithographische Prozeßschritte gebildet. Es wird eine Implantation mit n-dotierenden Ionen, zum Beispiel As mit einer Dosis von 1 x 10¹⁴ cm⁻² und einer Energie von 40 keV durchgeführt, bei der ein Auswahlschalter programmiert wird. Dabei werden Kanaldotierungen erzeugt an denjenigen Kreuzungspunkten der Bitauswahlleitungen BA mit den Bitleitungen BL, an denen keine Auswahltransistoren AT gebildet werden.

Nach Entfernen der Programmiermaske und des Streuoxids wird eine geeignete dielektrische Schicht auf die Bitleitungen 86 und die Isolationsgräben 85 aufgebracht. Die dielektrische Schicht kann vorzugsweise durch eine Mehrfachschicht gebildet werden. Besonders zweckmäßig ist es, wenn die dielektrische Schicht eine Dreifachschicht ist, mit einer ersten dielektrischen Schicht 90 aus Siliziumoxid SiO₂ in einer Dicke von ungefähr 3 nm, einer mittleren dielektrischen Schicht 100 aus Siliziumnitrid von ungefähr 7 bis 8 nm Dicke und einer oberen dielektrischen Schicht 110 aus Siliziumoxid mit einer Dicke von etwa 4 nm. Eine derartige Abfolge der Dicken der Schichten ist besonders zweckmäßig, um eingefangene Ladungen möglichst lange zu speichern.

Die erste dielektrische Schicht 90 wird zum Beispiel durch eine Temperung in einer O₂-haltigen Atmosphäre in einer gewünschten Schichtdicke gebildet. Hierbei wird das Silizium der Stege 30 in Siliziumoxid SiO₂ umgewandelt.

Die zweite dielektrische Schicht 100 wird vorzugsweise nach einem CVD (Chemical Vapour Deposition)-Verfahren aufgebracht, insbesondere nach einem LPCVD (Low Pressure CVD)-Verfahren. Eine besonders geeignete Variante zur Bildung der zweiten dielektrischen Schicht 100 nach dem LPCVD-Verfahren kann dadurch erfolgen, daß Dichlorsilan (SiH₂CL₂) unter Zugabe von Ammoniak (NH₃) bei einer Temperatur im Bereich von etwa 750 °C in einem Plasma bei einem Druck zwischen 10 Pa und 100 Pa, bevorzugt 30 Pa, in Siliziumnitrid (Si₃N₄) umgewandelt wird.

Anschließend wird die obere dielektrische Schicht 110 durch thermische Oxidation, vorzugsweise in einer H-O-haltigen Atmosphäre bei einer Temperatur um 900 °C und einem Zeitraum von etwa 2 Stunden oder nach einem der bekannten Schichterzeugungsverfahren, zum Beispiel einem HTO-Verfahren, abgeschieden. Eine Abscheidung mit einem HTO-Verfahren kann vorzugsweise dadurch geschehen, daß Dichlorsilan SiH₂Cl₂ in einer N₂O-haltigen Atmosphäre bei einer Temperatur von ungefähr 900 °C und einem Druck im Bereich von 40 Pa in Siliziumoxid SiO₂ umgewandelt wird.

Auf die obere dielektrische Schicht 110 wird eine erste Elektrodenschicht 120, beispielsweise aus hochdotiertem polykristallinen Silizium aufgewachsen. Eine bevorzugte Dotierung des polykristallinen Siliziums beträgt wenigstens 10²⁰ cm⁻³, wobei Dotierungen ab 10²¹ cm⁻³ besonders geeignet sind. Die erste Elektrodenschicht 120 kann alternativ auch aus einem Metallsilizid und/oder einem Metall gebildet werden.

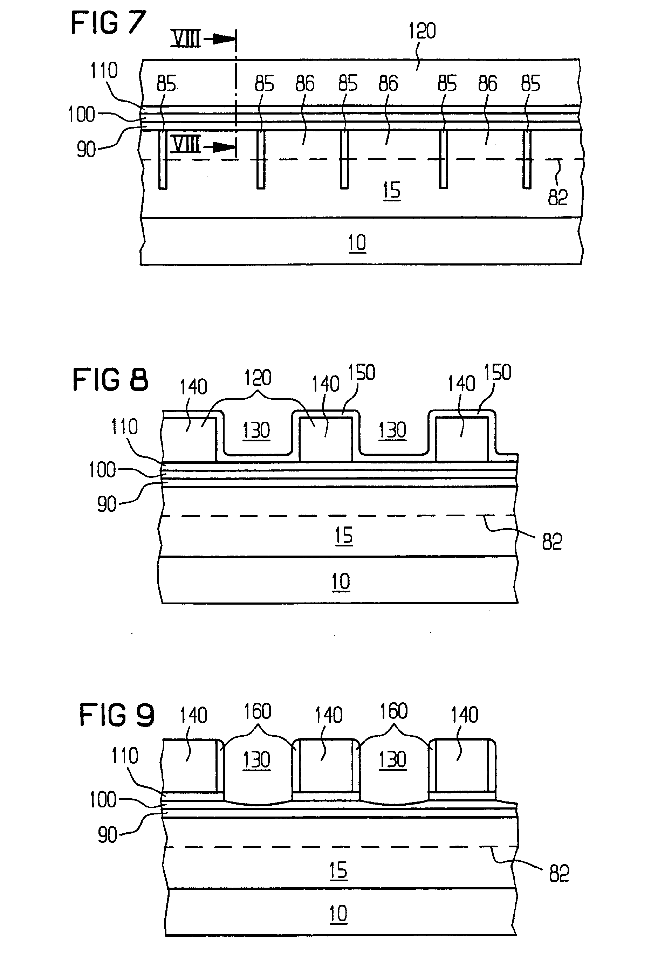

Beispielsweise ist die erste Elektrodenschicht 120 durch in situ dotierte Abscheidung oder undotierte Abscheidung und anschließende Implantation oder Diffusion eines Dotierstoffes dotiert. Vorzugsweise erfolgt eine n⁺-Dotierung, beispielsweise mit Phosphor oder Arsen. Die Elektrodenschicht 120 kann jedoch auch p⁺-dotiert sein. Eine Implantation erfolgt beispielsweise mit einer Energie von 80 keV und einer Dosis von 1 x 10¹⁶ cm⁻². Dieser Bearbeitungszustand des Halbleitersubstrats ist in Figur 7 dargestellt. Figur 7 ist ebenso wie die Figuren 2 bis 6 ein Querschnitt entlang der Linie VII - VII in Figur 1.

Anschließend wird eine Lackmaske auf die erste Elektrodenschicht 120 aufgetragen. Danach folgt ein Ätzprozeß, beispielsweise mehrstufig mit einem ersten Ätzschritt mit einem Gasgemisch aus CF₄ und O₂ oder CHF₃ und O₂ und einem zweiten Ätzschritt mit einem HBr-haltigen Gas. Hierdurch werden Gräben 130 in die erste Elektrodenschicht 120 geätzt. Zwischen den Gräben 130 entstehen durch das übriggebliebene Material der ersten Elektrodenschicht 120 Stege 140, die in der fertiggestellten Speicherzellenanordnung als Wortleitungen dienen. Parallel zu den Stegen 140 verlaufen weitere, aus Platzgründen nicht dargestellte Bitauswahlleitungen, die vorzugsweise auf die gleiche Weise wie die Wortleitungen hergestellt werden.

Alternativ kann die Übertragung der Lackmaske auch über eine vorher abgeschiedene Schicht, insbesondere eine Tetra-Ethyl-Ortho-Silikat (TEOS) - Schicht, erfolgen.

Anschließend wird auf die Stege 140 und die Gräben 130 eine Isolationsschicht 150 nach einem geeigneten, möglichst konformen Verfahren abgeschieden. Es ist besonders zweckmäßig, die Isolationsschicht 150 nach einem TEOS-Verfahren zu bilden. Dies kann dadurch erfolgen, daß Tetraethylorthosilikat Si(OC₂H₅)₄ bei einer Temperatur von ungefähr 700 °C und einem Druck im Bereich von 40 Pa in Siliziumoxid SiO₂ umgewandelt wird.

Der Ausschnitt des Halbleitersubstrats, in dem sich die dielektrischen Schichten 90, 100 und 110 sowie die Stege 140 befinden, ist in Figur 8 dargestellt. Figur 8 zeigt dabei einen Schnitt senkrecht zu den in den Figuren 2 bis 7 dargestellten Querschnitten entlang der in den Figuren 1 und 7 markierten Linie XIII - XIII.

Anschließend erfolgt eine anisotrope Ätzung der Isolationsschicht 150, wobei der Ätzabtrag dieses Ätzvorgangs der Dicke der Isolationsschicht 150 auf ebenen Gebieten entspricht. An den Seitenwänden der Stege 150 bleiben daher Abstandsstücke 160 stehen, die auch als TEOS-Spacer bezeichnet werden. Dieser Zustand des Halbleitersubstrats ist in Figur 9 dargestellt.

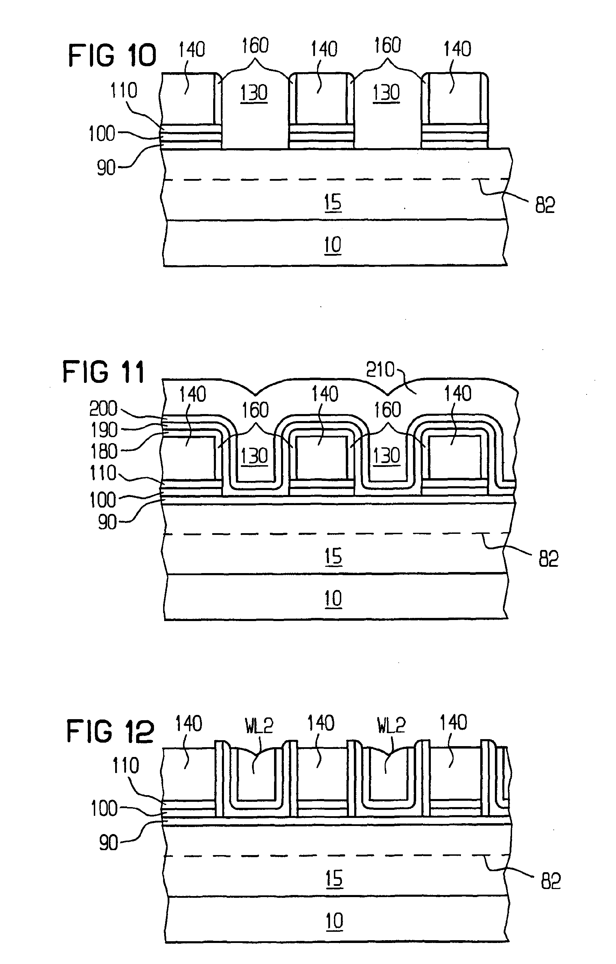

Anschließend erfolgt ein Ätzprozeß, wobei die nitridhaltige dielektrische Schicht 100 durch die Anwendung eines geeigneten Mittels, beispielsweise von Phosphorsäure mit einer Konzentration im Bereich von 80 % und einer Temperatur um 150°C entfernt wird. Der mehrstufige Ätzprozeß stoppt auf der oxidhaltigen unteren dielektrischen Schicht 90. Die dünne dielektrische Schicht 90 wird in dem Bereich der Gräben 130 durch einen weiteren Ätzvorgang, beispielsweise mit einer flußsäurehaltigen Lösung (HF-dip), entfernt. Dieser Zustand des Halbleitersubstrats ist in Figur 10 dargestellt.

Zur Verbesserung der Kristallqualität wird anschließend eine Opferschicht (ein sogenanntes sacrificial oxid), beispielsweise aus Siliziumoxid, aufgewachsen und mit Flußsäure geätzt (nicht dargestellt).

Danach wird eine weitere dielektrische Schicht abgeschieden. Die weitere dielektrische Schicht weist vorzugsweise den gleichen Aufbau auf wie die zuvor in den Gräben 130 entfernte dielektrische Schicht. Die dielektrische Schicht wird vorzugsweise durch eine Mehrfachschicht gebildet. Besonders zweckmäßig ist es, wenn die weitere dielektrische Schicht eine Dreifachschicht ist. Die Dreifachschicht wird zweckmäßigerweise so abgeschieden, daß in den Gräben 130 die erste dielektrischen Schicht 90 aus Siliziumoxid SiO₂ in einer Dikke von ungefähr 3 nm, die mittlere dielektrische Schicht 100 aus Siliziumnitrid von ungefähr 7 bis 8 nm Dicke und die obere dielektrische Schicht 110 aus Siliziumoxid mit einer Dicke von etwa 4 nm neu gebildet werden. Durch diesen Abscheidevorgang bilden sich auf den Stegen 140 eine untere dielektrische Schicht 180, eine mittlere dielektrische Schicht 190 und eine obere dielektrischen Schicht 200.

Vorzugsweise besteht die untere dielektrische Schicht 180 aus Siliziumoxid SiO₂, das zum Beispiel in einem Temperverfahren in einer gewünschten Schichtdicke gebildet wird. Hierbei wird im Oberflächenbereich der Stege 140 und des Halbleitermaterials 120 Silizium in einer sauerstoffhaltigen Atmosphäre bei einer Temperatur von ungefähr 800 bis 900 °C in Siliziumoxid SiO₂ umgewandelt. Die mittlere dielektrische Schicht 190 wird vorzugsweise durch eine Nitridschicht, die durch ein LPCVD-Verfahren bei ungefähr 700 °C erzeugt wurde, gebildet. Die oberste dielektrische Schicht 200 besteht vorzugsweise aus dem gleichen Material wie die untere dielektrische Schicht 180, also wiederum bevorzugt aus SiO₂. Die Dicke der unteren dielektrischen Schicht 180 beträgt im Endzustand beispielsweise 3 nm, die Dicke der mittleren dielektrischen Schicht 190 ungefähr 7 bis 8 nm und die Dicke der oberen dielektrischen Schicht 200 4 nm.

Durch das Auftragen der unteren dielektrischen Schicht 180 vergrößert sich die seitliche Ausdehnung der Abstandsstücke 160, wobei an den Abstandsstücken 160 auch vertikale Bereiche der Schichten 190 und 200 verbleiben.

Anschließend wird ganzflächig eine zweite Elektrodenschicht 210 gebildet. Die zweite Elektrodenschicht 210 besteht beispielsweise aus einem dotierten Halbleitermaterial, bevorzugt n-dotiertem polykristallinen Silizium, einem Metallsilizid und/oder einem Metall. Dieser Zustand des Halbleitersubstrats ist in Figur 11 dargestellt.

Das Halbleitermaterial der zweiten Elektrodenschicht 210 kann jedoch auch p-dotiert sein.

Die zweite Elektrodenschicht 210 wird in einer Dicke gebildet, die ausreicht, die Gräben 130 zwischen den Stegen 140 zu füllen. Die zweite Elektrodenschicht 210 wird deshalb in einer Dicke von ungefähr 0,2 µm bis 0,6 pm, bevorzugt 0,4 µm, abgeschieden.

Anschließend wird die zweite Elektrodenschicht 210 strukturiert. Durch Strukturierung der zweiten Elektrodenschicht 210 werden anschließend die zweiten Wortleitungen WL2 gebildet. Die ersten, in Figur 1 mit WL 1 bezeichneten, Wortleitungen werden durch die Stege 140 gebildet.

Die Strukturierung der zweiten Elektrodenschicht 210 erfolgt in einem mehrschrittigen Verfahren. Zunächst wird der obere Bereich der zweiten Elektrodenschicht 210 durch einen Planarisierungsprozeß, beispielsweise einen CMP-Schritt entfernt. Hierbei wirkt die mittlere dielektrische Schicht 190 als Stoppschicht.

Danach wird oberhalb der Stege 140 die weitere dielektrische Schicht durch das Entfernen ihrer Teilschichten 180, 190 und 200 entfernt. Danach erfolgt ein weiteres Rückätzen oder ein Prozeß des chemisch-mechanischen Planarisierens (CMP) (Figur 12).

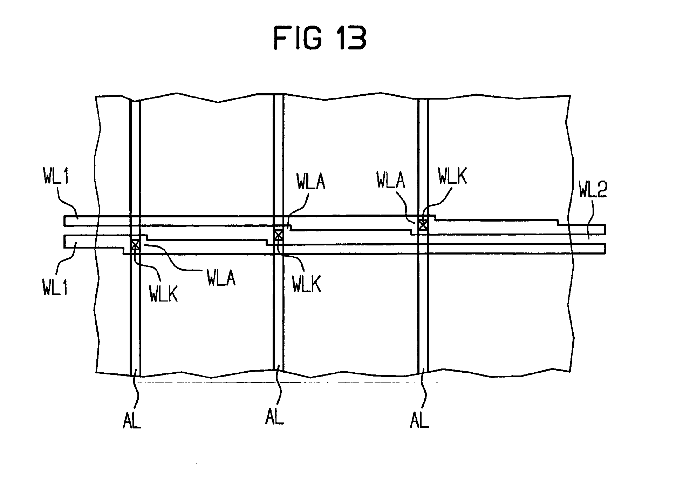

Zur besseren Kontaktierbarkeit der ersten Wortleitungen WL1 und der zweiten Wortleitungen WL2 werden diese so strukturiert, daß sie Wortleitungsaufweitungen WLA aufweisen, an denen Wortleitungskontakte WLK zu quer dazu verlaufenden Aluminiumbahnen AL gebildet werden (siehe Figur 13). Dazu werden die Wortleitungen WL1, WL2 so gebildet, daß sie im Bereich des Wortleitungskontaktes WLK einseitig verbreitert werden. Die Wortleitungsaufweitung WLA entsteht dadurch, daß diese einseitigen Verbreiterungen jeweils auf gegenüberliegenden Seiten der Wortleitung WL1, WL2 angeordnet sind. Vor und hinter der Wortleitungsaufweitung WLA ist die Breite der Wortleitung WL1, WL2 geringer als im Bereich der Wortleitungsaufweitung WLA. Ferner sind die Mitten der Wortleitungen WL1, WL2 vor und hinter der Wortleitungsaufweitung WLA gegeneinander versetzt. Die Wortleitungsaufweitungen WLA von benachbarten Wortleitungen WL1, WL2 sind gegeneinander versetzt angeordnet. Die Breite der Wortleitungen WL1, WL2 beträgt außerhalb der Wortleitungsaufweitungen WLA etwa die Hälfte des Wertes im Bereich der Wortleitungsaufweitung WLA. Auf diese Weise wird eine sichere Öffnung von Kontaktlöchern zur Bildung der Wortleitungskontakte WLK gewährleistet, ohne den Platzbedarf der Wortleitungen allzusehr zu vergrößern. Über das gesamte Zellenfeld bewirken die Wortleitungsaufweitungen WLA einen zusätzlichen Platzbedarf in Richtung der Breite der Wortleitungen WL1, WL2 von etwa einer Wortleitung je Segment. Ein Segment umfaßt zum Beispiel 32 bis 128 Wortleitungen.

Die Speicherzellenanordnung wird vervollständigt durch Abscheidung eines Zwischenoxids, Kontaktlochätzungen, Aufbringen und Strukturieren einer Metallschicht. Diese bekannten Prozeßschritte sind nicht dargestellt.

Vorzugsweise wird die dargestellte Speicherzellenanordnung mit einer Programmierspannung von ungefähr 12 V betrieben, wobei die zwischen benachbarten Bitleitungen auftretende Spannung etwa der halben Programmierspannung entspricht, also hier 6 V beträgt. Eine derartige Spannung zwischen benachbarten Bitleitungen wird durch eine Tiefe der Isolationsgräben 85 von etwa 100 nm bis mehreren 100 nm ausreichend sichergestellt.

## Patentansprüche

1. Speicherzellenanordnung,
- bei der im Bereich einer Hauptfläche eines Halbleitersubstrats (10) mehrere Speicherzellen vorhanden sind,
- bei der die Speicherzellen in im Wesentlichen parallel verlaufenden Speicherzellenzeilen angeordnet sind,
- bei der benachbarte Speicherzellenzeilen durch wenigstens einen Isolationsgraben (T, 85) gegeneinander isoliert sind,
- wobei die Speicherzellenanordnung wenigstens ein Gatedielektrikum, das ein Material mit Ladungsträger-Haftstellen enthält, aufweist,
- bei der die Speicherzellenzeilen jeweils wenigstens ein dotiertes Gebiet (D1, D2) aufweisen,
- bei der erste und zweite Wortleitungen (WL1, WL2) alternierend und im Wesentlichen senkrecht zu den Speicherzellenzeilen an der Oberfläche des Gatedielektrikums derart angeordnet sind, dass der Abstand zwischen den Wortleitungen (WL1, WL2) kleiner ist als ihre Breite,
- bei der die Speicherzellenzeilen in der Form von Stegen ausgebildet sind, wobei die Stege über eine Ebene des Halbleitersubstrats (10) hinausragen,
- bei der die Speicherzellenzeilen mehrteilig aufgebaut sind und in ihrem oberen Bereich wenigstens eine Bitleitung (86) enthalten,
- bei der das Gatedielektrikum oberhalb.der Bitleitung (86) angeordnet ist und wenigstens eine aus mehreren dielektrischen Schichten (90, 100, 110) gebildete dielektrische Mehrfachschicht enthält, wobei wenigstens eine dielektrische Schicht im Vergleich zu einer anderen einen Schicht einen erhöhten Ladungsträgereinfangquerschnitt aufweist, und
- bei der der Isolationsgraben (T; 85) schmaler ist als die Bitleitung (86) und tiefer in das Halbleitersubstrat (10) eindringt als die Bitleitung (86).

2. Speicherzellenanordnung nach Anspruch 1, **dadurch gekennzeichnet, dass** der Isolationsgraben (T; 85) die gleiche Höhe gegenüber dem Halbleitersubstrat (10) aufweist wie die Speicherzellenzeilen.

3. Speicherzellenanordnung nach Anspruch 2, **dadurch gekennzeichnet, dass** die Speicherzellenzeilen eine Höhe von 50 nm bis 200 nm aufweisen.

4. Speicherzellenanordnung nach einem der Ansprüche 1 bis 3, **dadurch gekennzeichnet, dass** das Gatedielektrikum zumindest bereichsweise Siliziumnitrid enthält.

5. Speicherzellenanordnung nach einem der Ansprüche 1 bis 4, **dadurch gekennzeichnet, dass** die dielektrische Mehrfachschicht aus einer unteren dielektrischen Schicht (90), einer mittleren dielektrischen Schicht (100) und einer oberen dielektrischen Schicht (110) besteht.

6. Speicherzellenanordnung nach Anspruch 5, **dadurch gekennzeichnet, dass** die Dicke der oberen dielektrischen Schicht (110) das 1,1-fache bis 2-fache der Dicke der unteren dielektrischen Schicht (90) beträgt.

7. Speicherzellenanordnung nach Anspruch 6, **dadurch gekennzeichnet, dass** die Dicke der oberen dielektrischen Schicht (110) ungefähr das 1,3-fache der Dicke der unteren dielektrischen Schicht (90) beträgt.

8. Speicherzellenanordnung nach Anspruch 7, **dadurch gekennzeichnet, dass** die Dicke der unteren dielektrischen Schicht (90) ungefähr 3 nm beträgt, die Dicke der mittleren dielektrischen Schicht (100) 7 nm bis 8 nm beträgt und die Dicke der oberen dielektrischen Schicht (110) ungefähr 4 nm beträgt.

9. Verfahren zur Herstellung einer Speicherzellenanordnung nach einem der Ansprüche 1 bis 8, bei dem im Bereich einer Hauptfläche eines Halbleitersubstrats (10) mehrere Speicherzellenzeilen erzeugt und gegeneinander isoliert werden, wobei auf die Hauptfläche des Halbleitersubstrats (10) zuerst erste Bereiche einer Ätzmaske derart aufgebracht werden, dass dann an Flanken der Bereiche Abstandsstücke (50) erzeugt werden, wobei nach dem Erzeugen der Abstandsstücke (50) zwischen den ersten Bereichen zweite Bereiche der Ätzmaske gebildet werden,
wobei in einem späteren Verfahrensschritt eine Ätzung der Abstandsstücke (50) selektiv zu den ersten Bereichen und den zweiten Bereichen der Ätzmaske erfolgt, und
wobei erste und zweite Wortleitungen (WL1, WL2) alternierend und im Wesentlichen senkrecht zu den Speicherzellenzeilen an der Oberfläche eines Gatedielektrikums derart ausgebildet werden, dass der Abstand zwischen den Wortleitungen (WL1, WL2) kleiner ist als ihre Breite.

10. Verfahren nach Anspruch 9, **dadurch gekenn**- **zeichnet**, dass die Abstandsstücke (50) dadurch erzeugt werden, dass auf die ersten Bereiche der Ätzmaske und auf nicht durch die ersten Bereiche der Ätzmaske bedeckte Bereiche des Halbleitersubstrats (10) eine Deckschicht (30) abgeschieden wird und dass dann Bereiche der Deckschicht (30), die sich parallel zu der Hauptfläche des Halbleitersubstrats (10) erstrecken, weggeätzt werden.

11. Verfahren nach einem der Ansprüche 9 oder 10,
**dadurch gekennzeichnet, dass** die ersten Bereiche der Ätzmaske so aufgebracht werden, dass sich zwischen ihnen wenigstens ein Zwischenraum bildet und dass ein Material (60) aufgebracht wird, das in den Zwischenraum gelangt, so dass sich in dem Zwischenraum wenigstens einer der zweiten Bereiche der Ätzmaske bildet.

12. Verfahren nach Anspruch 11, **dadurch gekennzeichnet, dass** das Material (60) so aufgebracht wird, dass es auch die ersten Bereiche der Ätzmaske und die Abstandsstücke (50) bedeckt.

13. Verfahren nach einem der Ansprüche 9 bis 12,
**dadurch gekennzeichnet, dass** die ersten Bereiche der Ätzmaske als parallele Stege (20) erzeugt werden.

14. Verfahren nach einem der Ansprüche 9 bis 13,
**dadurch gekennzeichnet, dass** die zweiten Bereiche der Ätzmaske als parallele Stege (80) erzeugt werden.

15. Verfahren nach einem der Ansprüche 9 bis 14,
**dadurch gekennzeichnet, dass** nach der Bildung der zweiten Bereiche der Ätzmaske ein Planarisierungsvorgang erfolgt.

16. Verfahren nach einem der Ansprüche 9 bis 15,
**dadurch gekennzeichnet, dass** auf einem Halbleitersubstrat (10), das Silizium enthält, eine Ätzmaske aufgetragen wird, deren erste Bereiche und zweite Bereiche aus Siliziumdioxid bestehen und dass die Abstandstücke (50) aus Siliziumnitrid gebildet werden.

17. Verfahren nach Anspruch 16, **dadurch gekennzeichnet, dass** die Ätzung der Abstandsstücke (50) selektiv zu den ersten Bereichen und den zweiten Bereichen der Ätzmaske mit Phosphorsäure als Ätzmittel erfolgt.

## Claims

1. Memory cell arrangement,
- in which a plurality of memory cells are arranged in the region of a main surface of a semiconductor substrate (10),
- in which the memory cells are arranged in memory cell rows which run essentially parallel,
- in which adjacent memory cell rows are insulated from one another by at least one insulating trench (T, 85),
- the memory cell arrangement having at least one gate dielectric which contains a material having charge carrier traps,
- in which the memory cell rows each have at least one doped region (D1, D2),
- in which first and second word lines (WL1, WL2) are arranged alternately and essentially perpendicular to the memory cell rows at the surface of the gate dielectric in such a way that the distance between the word lines (WL1, WL2) is smaller than the width thereof,
- in which the memory cell rows are structured in the form of webs, the webs protruding above a plane of the semiconductor substrate (10),
- in which the memory cell rows are designed in a plurality of parts and contain at least one bit line (86) in their top region,
- in which the gate dielectric is arranged above the bit line (86) and contains at least one dielectric multiple layer formed from a plurality of dielectric layers (90, 100, 110), where at least one dielectric layer has an increased charge carrier capture cross section as compared with another layer, and
- in which the insulating trench (T; 85) is narrower than the bit line (86), and penetrates deeper into the semiconductor substrate (10) than the bit line (86).

2. Memory cell arrangement according to Claim 1, **characterized in that** the insulating trench (T; 85) has the same height with respect to the semiconductor substrate (10) as the memory cell rows.

3. Memory cell arrangement according to Claim 2, **characterized in that** the memory cell rows have a height of 50 nm to 200 nm.

4. Memory cell arrangement according to one of Claims 1 to 3, **characterized in that** at least regions of the gate dielectric contain silicon nitride.

5. Memory cell arrangement according to one of Claims 1 to 4, **characterized in that** the dielectric multiple layer comprises a bottom dielectric layer (90), a middle dielectric layer (100) and a top dielectric layer (110).

6. Memory cell arrangement according to Claim 5, **characterized in that** the thickness of the top dielectric layer (110) is 1.1 times to twice the thickness of the bottom dielectric layer (90).

7. Memory cell arrangement according to Claim 6, **characterized in that** the thickness of the top dielectric layer (110) is approximately 1.3 times the thickness of the bottom dielectric layer (90).

8. Memory cell arrangement according to Claim 7, **characterized in that** the thickness of the bottom dielectric layer (90) is approximately 3 nm, the thickness of the middle dielectric layer (100) is 7 nm to 8 nm, and the thickness of the top dielectric layer (110) is approximately 4 nm.

9. Method for producing a memory cell arrangement according to one of Claims 1 to 8, in which a plurality of memory cell rows are produced and insulated from one another in the region of a main surface of a semiconductor substrate (10), wherein first regions of an etching mask are first applied to the main surface of the semiconductor substrate (10) in such a way that spacers (50) are then produced at edges of the regions, wherein, once the spacers (50) have been produced between the first regions, second regions of the etching mask are formed, wherein, in a later method step, the spacers (50) are etched selectively for the first regions and for the second regions of the etching mask, and wherein
first and second word lines (WL1, WL2) are formed alternately and essentially perpendicular to the memory cell rows at the surface of a gate dielectric in such a way that the distance between the word lines (WL1, WL2) is smaller than the width thereof.

10. Method according to Claim 9, **characterized in that** the spacers (50) are produced by depositing a cover layer (30) on the first regions of the etching mask and on regions of the semiconductor substrate (10) which are not covered by the first regions of the etching mask, and **in that** regions of the cover layer (30) which extend parallel to the main surface of the semiconductor substrate (10) are then etched away.

11. Method according to either of Claims 9 and 10, **characterized in that** the first regions of the etching mask are applied such that at least one interspace is formed between them, and **in that** a material (60) is applied which enters the interspace, so that at least one of the second regions of the etching mask is formed in the interspace.

12. Method according to Claim 11, **characterized in that** the material (60) is applied such that it also covers the first regions of the etching mask and the spacers (50).

13. Method according to one of Claims 9 to 12, **characterized in that** the first regions of the etching mask are produced as parallel webs (20).

14. Method according to one of Claims 9 to 13, **characterized in that** the second regions of the etching mask are produced as parallel webs (80).

15. Method according to one of Claims 9 to 14, **characterized in that**, once the second regions of the etching mask have been formed, a planarization procedure takes place.

16. Method according to one of Claims 9 to 15, **characterized in that** an etching mask whose first regions and second regions are made of silicon oxide is applied to a semiconductor substrate (10) containing silicon, and **in that** the spacers (50) are formed from silicon nitride.

17. Method according to Claim 16, **characterized in that** the spacers (50) are etched selectively for the first regions and for the second regions of the etching mask using phosphoric acid as etchant.

## Revendications

1. Agencement de cellules de mémoire
- dans lequel il y a plusieurs cellules de mémoire dans la partie d'une surface principale d'un substrat (10) semi-conducteur,
- dans lequel les cellules de mémoire sont disposées en lignes de cellules de mémoire s'étendant sensiblement parallèlement,
- dans lequel des lignes voisines de cellules de mémoire sont isolées l'une par rapport à l'autre par au moins un sillon (T,85) d'isolation,
- dans lequel l'agencement de cellules de mémoire a au moins un diélectrique de grille, qui contient un matériau ayant des pièges de porteur de charge,
- dans lequel les lignes de cellules de mémoire ont respectivement au moins une région (D1, D2) dopée,
- dans lequel des première et deuxième lignes (WL1,WL2) de mot sont disposées à la surface du diélectrique de grille en alternance et en étant sensiblement perpendiculaire aux lignes de cellules de mémoire de manière à ce que la distance entre les lignes (WL1, WL2) de mot soient plus petite que leur largeur,
- dans lequel les lignes de cellules de mémoire sont constituées sous la forme de nervures, les nervures dépassant d'un plan du substrat (10) à semi-conducteur,
- dans lequel les lignes de cellules de mémoire sont constituées en plusieurs parties et contiennent dans leur partie supérieure au moins une ligne (86) de bit,
- dans lequel le diélectrique de grille est disposé au-dessus de la ligne (86) de bit et contient au moins une couche diélectrique stratifiée, formée de plusieurs couches (90, 100, 110) diélectriques, au moins une couche diélectrique ayant une section transversale de capture de porteur de charge plus grande qu'une autre couche, et
- dans lequel le sillon (T,85) d'isolation est plus étroit que la ligne (86) de bit et pénètre plus profondément dans le substrat (10) semi-conducteur que la ligne (86) de bit.

2. Agencement de cellules de mémoire suivant la revendication 1, **caractérisé en ce que** le sillon (T,85) d'isolation a la même hauteur par rapport au substrat (10) semi-conducteur que les lignes de cellules de mémoire.

3. Agencement de cellules de mémoire suivant la revendication 2, **caractérisé en ce que** les lignes de cellules de mémoire ont une hauteur de 50 nm à 200 nm.

4. Agencement de cellules de mémoire suivant l'une des revendication 1 à 3, **caractérisé en ce que** le diélectrique de grille contient du nitrure de silicium au moins par zone.

5. Agencement de cellules de mémoire suivant l'une des revendications 1 à 4, **caractérisé en ce que** la couche stratifiée diélectrique est constituée d'une couche (90) diélectrique inférieure, d'une couche (100) diélectrique médiane et d'une couche (110) diélectrique supérieure.

6. Agencement de cellules de mémoire suivant la revendication 5, **caractérisé en ce que** l'épaisseur de la couche (110) diélectrique supérieure représente de 1,1 fois 2 fois l'épaisseur de la couche (90) diélectrique inférieure.

7. Agencement de cellules de mémoire suivant la revendication 6, **caractérisé en ce que** l'épaisseur de la couche (110) diélectrique supérieure représente à peu près 1,3 fois l'épaisseur de la couche (90) diélectrique inférieure.

8. Agencement de cellules de mémoire suivant la revendication 7, **caractérisé en ce que** l'épaisseur de la couche (90) diélectrique inférieure est à peu près de 3 nm, l'épaisseur de la couche (100) diélectrique médiane va de 7 nm à 8 nm et l'épaisseur de la couche (110) diélectrique supérieure est à peu près de 4 nm.

9. Procédé de fabrication d'un agencement de cellules de mémoire suivant l'une des revendications 1 à 8, dans lequel, dans la partie d'une surface principale d'un substrat (10) semi-conducteur, on produit plusieurs lignes de cellules de mémoire et on les isole les unes par rapport aux autres en déposant, sur la surface principale du substrat (10) semi-conducteur, d'abord de premières parties d'un masque d'attaque de manière à produire des espaceurs (50) sur les flancs des parties, dans lequel, après la production des espaceurs (50), on forme des deuxièmes parties du masque d'attaque entre les premières parties,
dans lequel, dans un stade ultérieur du procédé, on effectue une attaque des espaceurs (50) sélectivement par rapport aux premières parties et aux deuxièmes parties du masque d'attaque et
dans lequel on forme à la surface d'un diélectrique de grille des premières et deuxièmes lignes (WL1 , WL2) de mot en alternance et sensiblement perpendiculairement aux lignes de cellules de mémoire, de manière à ce que la distance entre les lignes (WL1 , WL2) de mot soient plus petite que leur largeur.

10. Procédé suivant la revendication 9, **caractérisé en ce que** l'on produit les espaceurs (50) en déposant une couche (30) supérieure sur les premières parties du masque d'attaque et sur des parties du substrat (10) semi-conducteur qui ne sont pas recouvertes par les premières parties du masque d'attaque et **en ce qu'**ensuite on enlève par attaque des parties de la couche (30) supérieure qui s'étendent parallèlement à la surface principale du substrat (10) semi-conducteur.

11. Procédé suivant l'une des revendications 9 ou 10, **caractérisé en ce que** l'on dépose les premières parties du masque d'attaque de manière à former entre elles au moins un espace intermédiaire, et **en ce qu'**on déposé un matériau (60) qui arrive dans l'espace intermédiaire de manière à former dans l'espace intermédiaire au moins l'une des deuxièmes parties du masque d'attaque.

12. Procédé suivant la revendication 11, **caractérisé en ce qu'**on dépose le matériau (60) de manière à ce qu'il recouvre aussi les premières parties du masque d'attaque et les espaceurs (50).

13. Procédé suivant l'une des revendications 9 à 12, **caractérisé en ce que** l'on produit les premières parties du masque d'attaque sous la forme de nervures (20) parallèles.

14. Procédé suivant l'une des revendications 9 à 13, **caractérisé en ce que** l'on produit les deuxièmes parties du masque d'attaque sous la forme de nervures (80) parallèles.

15. Procédé suivant l'une des revendications 9 à 14, **caractérisé en ce qu'**après la formation des deuxièmes parties du masque d'attaque on effectue une opération de planarisation.

16. Procédé suivant l'une des revendications 9 à 15, **caractérisé en ce que** l'on dépose sur un substrat (10) semi-conducteur, qui contient du silicium, un masque d'attaque dont les premières parties et les deuxièmes parties sont en dioxyde de silicium, et **en ce que** l'on forme les espaceurs (50) en nitrure de silicium.

17. procédé suivant la revendications 16, **caractérisé en ce que** l'on effectue l'attaque des espaceurs (50) sélectivement par rapport aux premières parties et aux deuxièmes parties du masque d'attaque, en prenant de l'acide phosphorique comme agent d'attaque.
